# EUROPEAN PATENT APPLICATION

(11) **EP 4 730 960 A1**
(43) Date of publication of application: **22.04.2026**
(21) Application number: 24899279.4
(22) Date of filing: 23.07.2024
(51) Int. Cl.: H10F 19/80

(54) **PHOTOVOLTAIC CELL STRING, PHOTOVOLTAIC CELL PANEL AND PHOTOVOLTAIC CELL MODULE**

(30) Priority: 04.12.2023 CN 202311642056
(71) Applicant: CHINT New Energy Technology Co., Ltd., Haining, Zhejiang 314400 (CN)
(72) Inventor: HE, Chenxu, Jiaxing, Zhejiang 314400 (CN); JIN, Yeyi, Jiaxing, Zhejiang 314400 (CN); WU, Guoxing, Jiaxing, Zhejiang 314400 (CN); YANG, Chenzhao, Jiaxing, Zhejiang 314400 (CN); HSU, Wei-Chih, Jiaxing, Zhejiang 314400 (CN)
(74) Representative: PGA S.p.A., Milano, Succursale di Lugano
(86) International application number: PCT/CN2024/107033
(87) International publication number: WO 2025/118628

(57) **Abstract**

A photovoltaic cell string, a photovoltaic cell panel and a photovoltaic cell module, which are applied to the field of photovoltaic cell preparation. The cell string comprises: a plurality of cells, welding strips, which are arranged on first surfaces and second surfaces of the cells, and protective films, which are arranged on outer sides of the welding strips, wherein there is an overlapping region between adjacent cells among the plurality of cells; and the protective films located on preset cell surfaces of the adjacent cells extend to the overlapping region, such that by using the protective films, the stress generated between the cells and the welding strips in the overlapping region is reduced; the preset cell surfaces are the surfaces of the sides of the adjacent cells where the cells are stacked on each other; and the adjacent cells form an electrical connection by means of the welding strips located on the preset cell surfaces. In the present application, the protective films located on the preset surfaces of the cells in the adjacent cells extend to the overlapping region, such that the stress generated between the cells and the welding strip can be reduced.

## Description

The present application claims priority to Chinese Patent Application No. CN202311642056.2, titled "PHOTOVOLTAIC CELL STRING, PHOTOVOLTAIC CELL PANEL AND PHOTOVOLTAIC CELL MODULE", filed on December 4, 2023 with the China National Intellectual Property Administration, which is incorporated herein by reference in its entirety.

### FIELD

The present application relates to the field of photovoltaic cell manufacturing, and in particular to a photovoltaic cell string, a photovoltaic cell panel, a photovoltaic cell module and a method for manufacturing the photovoltaic cell string.

### BACKGROUND

A photovoltaic module is a power generation module formed by interconnecting multiple photovoltaic cells into cell strings, and then encapsulating these strings after they are connected in series and parallel. Typically, there is a certain distance between adjacent cells and adjacent cell strings within the photovoltaic module, which may cause power loss.

During the formation of the photovoltaic cell strings, the interconnection points of cells need instant cooling during welding, and the abrupt temperature change generates stress between the cells and the welding strips. Therefore, welding strip shaping, segmented welding strips and other solutions are typically employed in the conventional technologies to flatten the welding strips between the adjacent cells, thereby reducing the stress between the cells and the welding strips. Alternatively, polyethylene terephthalate (PET) gaskets are adopted between the cells to avoid excessive pressure between the welding strips and the cells. However, the solutions involving the welding strip shaping and segmented welding strip have low compatibility with narrow welding strips, and the arrangement of the segmented welding strips and the solution involving PET gaskets pose significant manufacturing challenges, resulting in increased costs.

### SUMMARY

In view of this, an object of the present application is to provide a photovoltaic cell string, a photovoltaic cell panel, a photovoltaic cell module and a method for manufacturing the photovoltaic cell string, which addresses the issue in the conventional technologies where stress is generated between the cell and the welding strip due to the abrupt temperature change at the cell interconnection point during welding. Furthermore, it reduces non-power generation regions, solves the problem of hidden cracks in the cell caused by excessive pressure between the cell and the welding strip in the overlapping region of the negative spacing modules during lamination, and further improves the power generation efficiency of module packaging, while reducing the processing difficulty of module manufacturing and facilitating continuous production.

In order to address the above technical issues, a photovoltaic cell string is provided according to the present application, including:
multiple cells, welding strips arranged on first surfaces and second surfaces of the cells, and protective films arranged on outer sides of the welding strips.

There is an overlapping region between every two adjacent cells among the multiple cells.

The protective films located on preset cell surfaces of the adjacent cells extend into the overlapping region, such that stress generated between the cells and the welding strips in the overlapping region is reduced by means of the protective films. The preset cell surfaces refer to the surfaces, which are stacked one on top of another, of the adjacent cells.

The adjacent cells are electrically connected to each other by means of the welding strips located on the preset cell surfaces.

Optionally, the protective film located on the preset cell surface of one of the adjacent cells extends into the overlapping region.

Optionally, the protective films located on preset cell surfaces of both of the adjacent cells extend into the overlapping region, respectively.

Optionally, the protective film has an intact surface.

Optionally, an independent protective film is arranged on each of the first surface and the second surface of each of the cells.

Optionally, the protective film is a polymer film.

Optionally, the polymer film has a thickness ranging from 50µm to 150µm.

Optionally, the overlapping region between the adjacent cells has a length ranging from 0.2mm to 5mm.

Optionally, there is gap region formed between an edge of the protective film and an edge of the cell, allowing a portion of the preset cell surface to be exposed.

Optionally, the gap region is located at the edges of the adjacent cells that are opposite to each other.

Optionally, the gap region has a width ranging from 0.5mm to 10mm.

A photovoltaic cell panel is further provided according to the present application, including:
multiple photovoltaic cell strings as described above.

The multiple photovoltaic cell strings are laid and electrically connected to each other to form the photovoltaic cell panel.

Optionally, there is a cell string overlapping region between every two adjacent cell strings among the multiple photovoltaic cell strings.

The protective film located on a preset cell string surface of at least one of the adjacent cell strings extends into the cell string overlapping region. The preset cell string surfaces refer to the surfaces, which are stacked one on top of another, of the corresponding cells of the adjacent cell strings.

Optionally, the cell string overlapping region has a length less than 5mm.

A photovoltaic cell panel is further provided according to the present application, including:
multiple photovoltaic cell strings as described above.

The multiple photovoltaic cell strings are laid and electrically connected to each other to form the photovoltaic cell panel. There is a cell string overlapping region between every two adjacent cell strings among the multiple photovoltaic cell strings.

The protective film located on the preset cell string surface of each of the adjacent cell strings extends into the cell string overlapping region. The preset cell string surfaces refer to the surfaces, which are stacked one on top of another, of the corresponding cells of the adjacent cell strings.

A photovoltaic cell module is further provided according to the present application, including:
a first panel, a first adhesive film layer, a second panel, a second adhesive film layer, and the photovoltaic cell panel as described above.

The first adhesive film layer and the second adhesive film layer are arranged on both sides of the photovoltaic cell panel respectively, and the photovoltaic cell panel is sealed between the first adhesive film layer and the second adhesive film layer.

The first panel is arranged on an outer side of the first adhesive film layer, and the second panel is arranged on an outer side of the second adhesive film layer.

A method for manufacturing a photovoltaic cell string is further provided according to the present application, including:
grasping back protective films by negative pressure absorption, placing the back protective films on a surface of a supporting platform, and fixing the back protective films to the surface of the supporting platform by negative pressure absorption;
placing back welding strips and cells sequentially in a preset direction such that an overlapping region is formed between every two adjacent cells among the plurality of cells;
placing front welding strips and front protective films sequentially in a preset direction to form a photovoltaic cell string to be laminated, wherein in the photovoltaic cell string to be laminated, the protective films located on the preset cell surfaces of the adjacent cells extend into the overlapping region, and the preset cell surfaces refer to the surfaces, stacked one on top of another, of the adjacent cells; and
heating and pre-laminating the protective films to obtain the photovoltaic cell string.

Optionally, after heating and pre-laminating the protective films to obtain the photovoltaic cell string, the method further includes:
arranging protective adhesive film layers on both sides of the photovoltaic cell string respectively, and laminating them so as to weld and fix the back welding strips and the front welding strips to grid on cell surfaces.

The terms such as "back" and "front" described in the present application are defined relative to the surface of the supporting platform during the manufacturing process, and have no relation to the light-collecting surface or backlight surface of the photovoltaic cell and the photovoltaic module. It can be seen that the photovoltaic cell string according to the present application includes: multiple cells, welding strips arranged on first surfaces and second surfaces of the cells, and protective films arranged on outer sides of the welding strips. There is an overlapping region between every two adjacent cells among the multiple cells. The protective films located on preset cell surfaces of the adjacent cells extend into the overlapping region, such that the stress generated between the cells and the welding strips in the overlapping region is reduced by means of the protective films. The preset cell surfaces refer to surfaces, which are stacked one on top of another, of the adjacent cells. The adjacent cells are electrically connected to each other by means of the welding strips located on the preset cell surfaces. In the present application, the protective films located on the preset cell surfaces of the adjacent cells extend into the overlapping region, such that the area of the non-power generation region within the module may be reduced, and the stress generated between the cells and the welding strips may be reduced. Furthermore, the manufacturing difficulty of the photovoltaic cell string may be reduced, and the manufacturing cost may be reduced, thereby improving the manufacturing efficiency of the photovoltaic cell string.

In addition, a photovoltaic cell panel and a photovoltaic cell module are provided according to the present application, which similarly have the above beneficial effects.

### BRIEF DESCRIPTION OF THE DRAWINGS

In order to describe the technical solutions in the embodiments of the present application or in the conventional technology more clearly, the drawings required for describing the embodiments or the conventional technology are briefly introduced hereinafter. Apparently, the drawings in the following description show merely the embodiments of the present application, and those skilled in the art can obtain other drawings based on these drawings without creative efforts.
FIG. 1 is a schematic structural view of a photovoltaic cell string according to an embodiment of the present application;
FIG. 2 is a schematic top structural view of a photovoltaic cell string according to an embodiment of the present application;
FIG. 3 is a schematic structural view of a zero-busbar cell in a photovoltaic cell string according to an embodiment of the present application;
FIG. 4 is a schematic cross-sectional view of interconnected cells in a photovoltaic cell string according to an embodiment of the present application;
FIG. 5 is a schematic structural view of another photovoltaic cell string according to an embodiment of the present application;
FIG. 6 is a schematic structural view of a photovoltaic cell panel according to an embodiment of the present application;
FIG. 7 is a schematic structural view of a photovoltaic cell module according to an embodiment of the present application;
FIG. 8 is a flow chart of a method for manufacturing a photovoltaic cell string according to an embodiment of the present application;

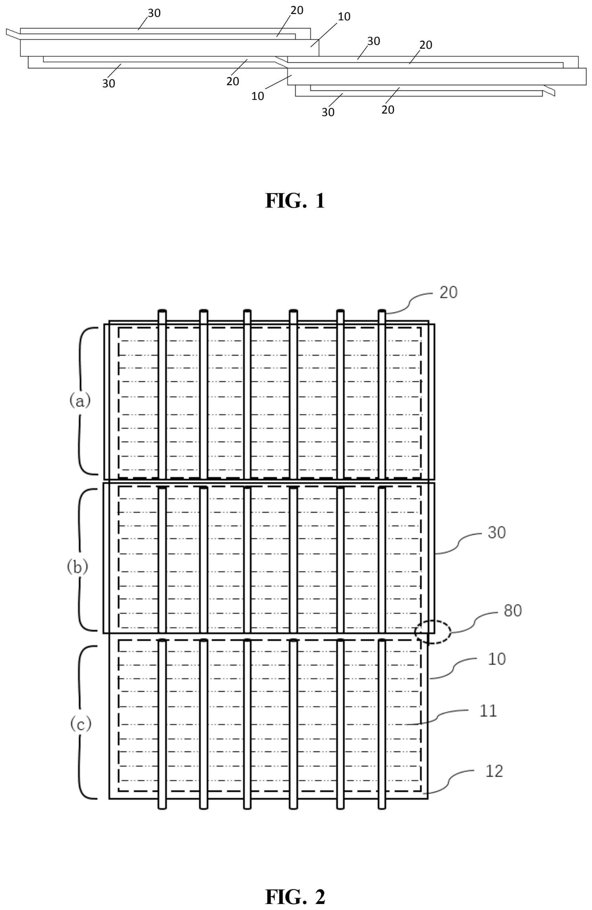

Reference numerals in FIG. 1 to FIG. 7 are described as follows:

| | | | |
|---|---|---|---|
| 10 | cell; | 11 | cell finger; |
| 12 | cell edge blank region; | 13 | overlapping region; |
| 20 | welding strip; | 30 | protective film; |
| 40 | first panel; | 50 | first adhesive film layer; |
| 60 | second panel; | 70 | second adhesive film layer; |
| 80 | gap region. | | |

### DETAILED DESCRIPTION OF THE EMBODIMENTS

In order to make the objects, technical solutions and advantages of the embodiments of the present application clearer, the technical solutions in the embodiments of the present application will be described clearly and completely hereinafter with reference to the drawings in the embodiments of the present application. Apparently, the described embodiments are some of the embodiments of the present application, rather than all of the embodiments. Based on the embodiments of the present application, all other embodiments obtained by those skilled in the art without any creative work fall into the protection scope of the present application.

The first embodiment is described as follows.

Reference is made to FIG. 1, which is a schematic structural view of a photovoltaic cell string according to an embodiment of the present application.

The photovoltaic cell string may include: multiple cells 10, welding strips 20 arranged on first surfaces and second surfaces of the cells 10, and protective films 30 arranged on outer sides of the welding strips 20.

There is an overlapping region between every two adjacent cells 10 among the multiple cells 10.

The protective films 30 located on preset cell surfaces of the adjacent cells 10 extend into the overlapping region, such that the stress generated between the cells 10 and the welding strips 20 in the overlapping region is reduced by means of the protective films. The preset cell surfaces refer to the surfaces of the cells on the sides where the adjacent cells 10 are stacked on each other.

The adjacent cells 10 are electrically connected to each other by means of the welding strips 20 located on the preset cell surfaces.

It should be noted that in this embodiment, multiple welding strips 20 may be arranged on both sides of multiple cells 10, respectively, and the protective films 30 may be arranged on outer sides of the multiple welding strips 20, so as to fix the welding strips 20 on the surfaces of the cells 10 by utilizing the protective films 30. In this embodiment, in order to reduce the distance between the adjacent cells 10, the edge regions of the adjacent cells 10 that are connected in series to form the cell string are stacked on each other to form the above-mentioned overlapping region, and the protective films 30 are extended into the above-mentioned overlapping region. In this embodiment, the specific structure of the protective films 30 extending into the overlapping region is not limited, as long as it may reduce the stress generated between the cells 10 and the welding strips 20 in the overlapping region. For example, the protective film 30 on the preset cell surface of one of the adjacent cells 10 may extend into the above-mentioned overlapping region, or alternatively, the protective films 30 on the preset cell surfaces of both of the adjacent cells 10 may extend into the above-mentioned overlapping region, respectively. In this embodiment, the welding strips 20 located on the preset cell surfaces of the adjacent cells 10 are interconnected so that a negative electrode of one of the adjacent cells 10 is connected to a positive electrode of the other of the adjacent cells 10, thereby achieving a series connection between the adjacent cells 10. Furthermore, the above protective film may have an intact surface, or alternatively, a protective film with a hollow structure on its surface may be selected to reduce the manufacturing cost. However, in order to ensure the convenience of manufacturing, the hollow structure on the surface of the protective film may be designed in such a way that it should not interfere with the negative-pressure suction and grasping of the protective film. In this embodiment, the welding strip 20 may be composed of a conductive core and a surface coating, which melts at the lamination temperature of the module. In this embodiment, the structure of the photovoltaic cell string may be referred to FIG. 2, which is a schematic top structural view of a photovoltaic cell string according to an embodiment of the present application. The cell edge blank region 12 is a non-power generation region, which is the region reduced through overlapping in the present application. In FIG. 2, the overlapping of three cells 10 is taken as an example, including three cells arranged as shown in (a), (b), and (c) of FIG. 2, which are connected in series by the welding strips 20 to form a photovoltaic cell string. Cell fingers 11 are configured as collectors of the photovoltaic cell 10, which are configured for collecting the photocurrent generated on the surface of the photovoltaic cell. The protective film 30 may be a polymer film that covers the surface of single photovoltaic cell 10, configured to absorb the welding strips 20. The adjacent cells 10 are stacked on each other. Preferably, each cell 10 may be covered with a corresponding polymer film, and the polymer film isolates the adjacent cells 10 in the overlapping region.

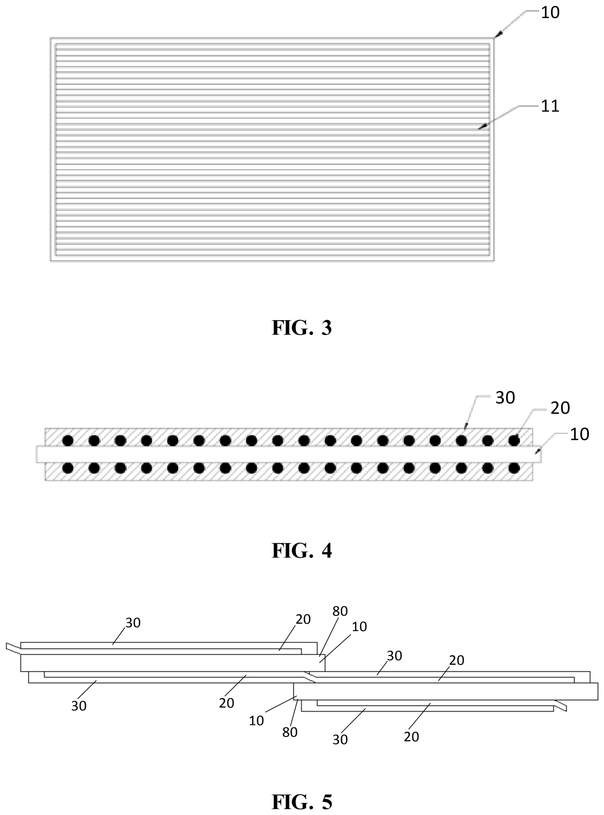

Accordingly, the specific material of the protective film 30 is not limited in this embodiment, as long as the protective film 30 is arranged in the overlapping region and the stress generated between the adjacent cells 10 and the welding strips 20 in the overlapping region can be reduced. Additionally, the specific thickness of the protective film 30 is not limited in this embodiment, and it may be adjusted based on actual conditions, for example, based on simulation experiments. Similarly, the specific length of the protective film 30 extending into the overlapping region is not limited in this embodiment, and for example, it may cover the entire overlapping region. Furthermore, the specific length of the formed overlapping region is not limited in this embodiment, as long as it does not shade the light-collecting region of the cell 10. In this embodiment, the cell 10 may preferably be a zero-busbar cell. For details, reference is made to FIG. 3, which is a schematic structural view of a zero-busbar cell in a photovoltaic cell string according to the embodiment of the present application, including cell fingers 11. Preferably, the cell 10 is a double-sided cell such as an HJT (Heterojunction with Intrinsic Thin layer) cell or a TOPCon (Tunnel Oxide Passivated Contact) cell. The cell 10 is preferably rectangular in shape, with square being the second optimal option. The welding strip 20 may be a copper strip coated with SnBiAg (tin-bismuth-silver) coating.

Further, the interconnection structure of the adjacent cells in this embodiment may be referred to FIG. 4, which is a schematic cross-sectional view of the interconnection structure of cells in a photovoltaic cell string according to an embodiment of the present application. It can be seen that the multiple interconnected welding strips may be arranged between the adjacent cells.

Furthermore, in order to ensure the fixation of the cell during the manufacturing process, a gap region 80 may be formed between an edge of the protective film 30 and an edge of the cell 10, allowing a portion of the preset cell surface to be exposed.

In this embodiment, the gap region 80 is formed between the edge of the cell 10 and the edge of the protective film 30, so that the cell 10 may be absorbed and fixed by a bottom supporting platform through the gap region 80 during the manufacturing process, thereby improving the manufacturing efficiency.

Furthermore, the gap region 80 may be located at the edges of adjacent cells that are opposite to each other in order to improve the stability of the suction of the cells.

In this embodiment, the gap region 80 is formed between the adjacent cells and at mutually opposing edges of the adjacent cells, which facilitates more stable absorption and fixation of the cells.

Furthermore, in order to ensure that the gap region 80 does not interfere with other components of the cell, the gap region 80 may have a width ranging from 0.5mm to 10mm.

The photovoltaic cell string according to the embodiment of the present application includes multiple cells 10, welding strips 20 arranged on first surfaces and second surfaces of the cells 10, and protective films 30 arranged on outer sides of the welding strips 20. There is an overlapping region between every two adjacent cells 10 among the multiple cells 10. The protective films 30 located on preset cell surfaces of the adjacent cells 10 extend into the overlapping region, such that the stress generated between the cells 10 and the welding strips 20 in the overlapping region is reduced by means of the protective films 30. The preset cell surfaces refer to the surfaces on the sides where the adjacent cells 10 are stacked on each other. The adjacent cells 10 are electrically connected to each other by means of the welding strips 20 located on the preset cell surfaces. In the present application, by extending the protective films 30 located on the preset cell surfaces of the adjacent cells 10 into the overlapping region, the area of the non-power generation region within the module is reduced, and the stress generated between the cells 10 and the welding strips 20 is reduced. Furthermore, the manufacturing difficulty of the photovoltaic cell string may be reduced, and the manufacturing cost is reduced, thereby improving the manufacturing efficiency of the photovoltaic cell string. In addition, in the embodiment of the present application, the gap region 80 formed between the edge of the cell and the edge of the protective film allows the cell to be absorbed and fixed by the bottom supporting platform through the gap region 80 during manufacturing. The gap region 80 is located at the edges of adjacent cells that are opposite to each other, which facilitates more stable suction and fixation of the cells.

The second embodiment is described as follows.

A photovoltaic cell string according to this embodiment may include:
multiple cells, welding strips arranged on first surfaces and second surfaces of the cells, and protective films arranged on outer sides of the welding strips.

There is an overlapping region between every two adjacent cells among the multiple cells.

The protective film located on a preset cell surface of one of the adjacent cells extends into the overlapping region, such that the stress generated between the cells and the welding strips in the overlapping region is reduced by means of the protective films. The preset cell surfaces refer to the surfaces of the cells on the sides where the adjacent cells are stacked on each other.

The adjacent cells are electrically connected to each other by means of the welding strips located on the preset cell surfaces.

It should be noted that in this embodiment, the protective film on the preset cell surface of one of adjacent cells extends into the overlapping region, such that the stress generated between the adjacent cells and the welding strips in the overlapping region can be reduced, the manufacturing cost may be reduced, and the module thickness may be ensured, thereby improving the manufacturing efficiency of the photovoltaic cell string.

The photovoltaic cell string according to the embodiment of the present application includes multiple cells, welding strips arranged on first surfaces and second surfaces of the cells, and protective films arranged on outer sides of the welding strips. There is an overlapping region between every two adjacent cells among the multiple cells. The protective film located on the preset cell surface of one of the adjacent cells extends into the overlapping region, such that the stress generated between the cells and the welding strips in the overlapping region is reduced by means of the protective films. The preset cell surfaces refer to the surfaces on the sides where the adjacent cells are stacked on each other. The adjacent cells are electrically connected to each other by means of the welding strips located on the preset cell surfaces. In the present application, the protective films on the preset cell surfaces of the adjacent cells extend into the overlapping region, such that the stress generated between the cells and the welding strips may be reduced, and the manufacturing difficulty of the photovoltaic cell string may be reduced. The protective film located on the preset cell surface of one of the adjacent cells extends into the overlapping region, such that the area of the non-power generation region in the module may be reduced, and the stress generated between the adjacent cells and the welding strips may be reduced. Furthermore, the manufacturing cost may be reduced, and the module thickness may be ensured, thereby improving the manufacturing efficiency of the photovoltaic cell string.

The third embodiment is described as follows.

Reference is made to FIG. 5, which is a schematic structural view of another photovoltaic cell string according to an embodiment of the present application. The cell string may include:
multiple cells 10, welding strips 20 arranged on first surfaces and second surfaces of the cells 10, and protective films 30 arranged on outer sides of the welding strips 20.

There is an overlapping region between every two adjacent cells 10 among the multiple cells 10.

The protective films 30 located on preset cell surfaces ofboth of the adjacent cells 10 extend into the overlapping region, such that the stress generated between the cells 10 and the welding strips 20 in the overlapping region is reduced by using the protective films 30. The preset cell surfaces refer to the surfaces of the cells 10 on the sides where the adjacent cells 10 are stacked on each other.

The adjacent cells 10 are electrically connected to each other by means of the welding strips 20 located on the preset cell surfaces.

In this embodiment, by extending the protective films 30 on the cell preset surfaces of both of the adjacent cells 10 into the overlapping region, further isolation between the welding strips 20 and the cells 10 can be achieved, thereby further improving the anti-hidden crack performance of the photovoltaic cell string. In this embodiment, the specific structure of the protective films 30 on the cell preset surfaces of both of the adjacent cells 10 extending into the overlapping region is not limited, as long as it can prevent contact between the welding strips 20 and the cells 10 in the overlapping region. Further, in this embodiment, the thickness of the protective film 30 may range from 40µm to 120µm, and the welding strip 20 may have a diameter ranging from 0.17mm to 0.27mm. A dimension of the protective film extending into the overlapping region may have a deviation of 0.2mm from that of the overlapping region.

Furthermore, in order to ensure the manufacturing efficiency of the photovoltaic cell string, the above protective film 30 may have an intact surface.

In this embodiment, the protective film 30 has an intact surface. During the manufacturing of the photovoltaic cell string, the protective film 30 may be absorbed by negative pressure, which facilitates the mounting and manufacturing of the photovoltaic cell string, thereby improving the automation degree and ensuring the manufacturing efficiency of the cell string.

The photovoltaic cell string according to this embodiment of the present application includes: multiple cells 10, welding strips 20 arranged on first surfaces and second surfaces of the cells 10, and protective films 30 arranged on outer sides of the welding strips 20. There is an overlapping region between every two adjacent cells 10 among the multiple cells 10. The protective films 30 located on preset cell surfaces of both of the adjacent cells 10 extend into the overlapping region, such that the stress generated between the cells 10 and the welding strips 20 in the overlapping region is reduced by using the protective films 30. The preset cell surfaces refer to the surfaces of the cells 10 on the sides where the adjacent cells 10 are stacked on each other. The adjacent cells 10 are electrically connected to each other by means of the welding strips 20 located on the preset cell surfaces. In the present application, extending the protective films 30 located on the preset cell surfaces of the adjacent cells 10 into the overlapping region not only reduces the area of the non-power generation region in the module, but also reduces the stress generated between the cells 10 and the welding strips 20. Furthermore, the manufacturing difficulty of the photovoltaic cell string may be reduced, and the manufacturing cost may be reduced, thereby improving the manufacturing efficiency of the photovoltaic cell string. By extending the protective films 30 on the cell preset surfaces of both of the adjacent cells 10 into the overlapping region, the area of the non-power generation region inside the module can be reduced, and further isolation between the welding strips 20 and the cells 10 can be achieved, thereby further improving the anti-hidden crack performance of the photovoltaic cell string. In addition, in this embodiment of the present application, the protective film 30 has an intact surface, such that the protective film 30 may be absorbed by negative pressure, thereby improving the automation degree and ensuring the manufacturing efficiency of the cell string.

The fourth embodiment is described as follows.

The photovoltaic cell string according to this embodiment may include:
multiple cells, welding strips arranged on first surfaces and second surfaces of the cells, and protective films arranged on outer sides of the welding strips.

There is an overlapping region between every two adjacent cells among the multiple cells.

The protective films located on preset cell surfaces of the adjacent cells extend into the overlapping region, such that the stress generated between the cells and the welding strips in the overlapping region is reduced by means of the protective films. The preset cell surfaces refer to the surfaces of the cells on the sides where the adjacent cells are stacked on and in contact with each other.

The adjacent cells are electrically connected to each other by means of the welding strips located on the preset cell surfaces.

Independent protective films are arranged on the first surface and the second surface of each cell, respectively.

It should be noted that in this embodiment, by providing independent protective films on the first and second surfaces of each cell respectively, the bending of the protective films is avoided, and the complexity of manufacturing is reduced. Furthermore, the modular design of the protective films, with each side surface of each cell corresponding to an independent protective film, reduces the difficulty of aligning the protective films during mounting, thereby improving the manufacturing efficiency.

The photovoltaic cell string according to the embodiment of the present application includes: multiple cells, welding strips arranged on first surfaces and second surfaces of the cells, and protective films arranged on outer sides of the welding strips. There is an overlapping region between every two adjacent cells among the multiple cells. The protective films located on preset cell surfaces of the adjacent cells extend into the overlapping region, such that the stress generated between the cells and the welding strips in the overlapping region is reduced by means of the protective films. The preset cell surfaces refer to the surfaces of the cells on the sides where the adjacent cells are stacked on and in contact with each other. The adjacent cells are electrically connected to each other by means of the welding strips located on the preset cell surfaces. Independent protective films are arranged on the first surface and the second surface of each cell, respectively. In the present application, the protective films located on the preset cell surfaces of the adjacent cells extend into the overlapping region, such that the area of the non-power generation region within the module is reduced, and the stress generated between the cells and the welding strips is reduced. Furthermore, the manufacturing difficulty of the photovoltaic cell string may be reduced, and the manufacturing cost may be reduced, thereby improving the manufacturing efficiency of the photovoltaic cell string. Independent protective films are provided on the first and second surfaces of each cell, respectively, such that the bending of the protective films is avoided, and the complexity of manufacturing is reduced.

The fifth embodiment is described as follows.

The photovoltaic cell string according to this embodiment may include:
multiple cells, welding strips arranged on first surfaces and second surfaces of the cells, and protective films arranged on outer sides of the welding strips.

There is an overlapping region between every two adjacent cells among the multiple cells.

The protective films located on preset cell surfaces of the adjacent cells extend into the overlapping region, such that the stress generated between the cells and the welding strips in the overlapping region is reduced by means of the protective films. The preset cell surfaces refer to the surfaces of the cells on the sides where the adjacent cells are stacked on and in contact with each other.

The adjacent cells are electrically connected to each other by means of the welding strips located on the preset cell surfaces.

The protective film is a polymer film.

It should be noted that in this embodiment, the protective film is provided as a polymer film, such that the effectiveness of the polymer film in reducing stress may be ensured. Moreover, the polymer film is easy to process and mold, with low manufacturing cost, thereby further improving the manufacturing efficiency. The polymer film may be made of Polyethylene-Octene Elastomer (POE) material. When heated to about 140°C, the polymer film is absorbed to the cell.

Furthermore, in order to ensure the effectiveness of the polymer film in reducing stress, the thickness of the polymer film may range from 50µm to 150µm.

It should be noted that in this embodiment, the thickness of the polymer film ranges from 50µm to 150µm, which may effectively reduce the stress generated between adjacent cells and welding strips in the overlapping region due to the sudden temperature drop, thereby improving the yield of the photovoltaic cell string.

The photovoltaic cell string in this embodiment of the present application includes: multiple cells, welding strips arranged on first surfaces and second surfaces of the cells, and protective films arranged on outer sides of the welding strips. There is an overlapping region between every two adjacent cells among the multiple cells. The protective films located on preset cell surfaces of the adjacent cells extend into the overlapping region, such that the stress generated between the cells and the welding strips in the overlapping region is reduced by means of the protective films. The preset cell surfaces refer to the surfaces of the cells on the sides where the adjacent cells are stacked on and in contact with each other. The adjacent cells are electrically connected to each other by means of the welding strips located on the preset cell surfaces. The protective film is a polymer film. In the present application, the protective films located on the preset cell surfaces of the adjacent cells extend into the overlapping region, such that the area of the non-power generation region within the module is reduced, and the stress generated between the cells and the welding strips is reduced. Furthermore, the manufacturing difficulty of the photovoltaic cell string may be reduced, and the manufacturing cost may be reduced, thereby improving the manufacturing efficiency of the photovoltaic cell string. By providing the protective film as a polymer film, the effectiveness of the polymer film in reducing stress may be ensured, and the processing convenience of the protective film may be enhanced. In addition, in the embodiment of the present application, the thickness of the polymer film ranges from 50µm to 150µm, which effectively reduces the stress generated between the adjacent cells and the welding strips in the overlapping region, thereby improving the yield of the photovoltaic cell string.

The sixth embodiment is described as follows.

The photovoltaic cell string according to this embodiment may include:
multiple cells, welding strips arranged on first surfaces and second surfaces of the cells, and protective films arranged on outer sides of the welding strips.

There is an overlapping region between every two adjacent cells among the multiple cells.

The protective films located on preset cell surfaces of the adjacent cells extend into the overlapping region, such that the stress generated between the cells and the welding strips in the overlapping region is reduced by means of the protective films. The preset cell surfaces refer to the surfaces of the cells on the sides where the adjacent cells are stacked on and in contact with each other.

The adjacent cells are electrically connected to each other by means of the welding strips located on the preset cell surfaces.

The overlapping region between the adjacent cells has a length ranging from 0.2mm to 5mm.

In this embodiment, the length of the overlapping region between the adjacent cells ranges from 0.2mm to 5mm, which may reduce the gap between the adjacent cells while ensuring that the light-collecting region of the cells is not blocked, thereby improving the light-collecting efficiency.

The photovoltaic cell string according to the embodiment of the present application includes: multiple cells, welding strips arranged on first surfaces and second surfaces of the cells, and protective films arranged on outer sides of the welding strips. There is an overlapping region between every two adjacent cells among the multiple cells. The protective films located on preset cell surfaces of the adjacent cells extend into the overlapping region, such that the stress generated between the cells and the welding strips in the overlapping region is reduced by means of the protective films. The preset cell surfaces refer to the surfaces of the cells on the sides where the adjacent cells are stacked on and in contact with each other. The adjacent cells are electrically connected to each other by means of the welding strips located on the preset cell surfaces. The overlapping region between the adjacent cells has a length ranging from 0.2mm to 5mm. In the present application, the protective films located on the preset cell surfaces of the adjacent cells extend into the overlapping region, such that the area of the non-power generation region within the module may be reduced, and the stress generated between the cells and the welding strips may be reduced. Furthermore, the manufacturing difficulty of the photovoltaic cell string may be reduced, and the manufacturing cost may be reduced, thereby improving the manufacturing efficiency of the photovoltaic cell string. The length of the overlapping region between the adjacent cells ranges from 0.2mm to 5mm, which may reduce the gap between the adjacent cells while ensuring that the light-collecting region of the cells is not blocked, thereby improving the light-collecting efficiency.

To facilitate a better understanding of the embodiments of the present application, the photovoltaic cell string may specifically include:
multiple cells, welding strips arranged on first surfaces and second surfaces of the cells, and protective films arranged on outer sides of the welding strips.

The protective film has an intact surface.

There is an overlapping region between every two adjacent cells among the multiple cells. The protective films located on preset cell surfaces of both of the adjacent cells extend into the overlapping region respectively, such that the stress generated between the cells and the welding strips in the overlapping region is reduced by means of the protective films. The preset cell surfaces refer to the surfaces of the cells on the sides where the adjacent cells are stacked on and in contact with each other.

The adjacent cells are electrically connected to each other by means of the welding strips located on the preset cell surfaces.

Independent protective films are arranged on the first surface and the second surface of each cell, respectively. The protective film is a polymer film. The protective film has a thickness ranging from 50µm to 150µm.

The overlapping region between the adjacent cells has a length ranging from 0.2mm to 5mm.

There is a gap region 80 formed between an edge of the protective film and an edge of the cell, allowing a portion of the preset cell surface to be exposed, so that the cell is absorbed and fixed to the bottom supporting platform through the gap region 80 during manufacturing.

Furthermore, the gap region 80 is located at the edges of the adjacent cells that are opposite to each other. Preferably, the edge of the protective film on the back of the cell is staggered with the edge of the cell, forming the gap region 80. The gap region 80 is located below the overlapping region between the adjacent cells, with a width ranging from 0.5mm to 10mm, thereby allowing the supporting platform to more stably absorb and fix the cells.

A photovoltaic cell panel according to an embodiment of the present application is described below. The photovoltaic cell panel described below and the photovoltaic cell string described above may be referred to each other.

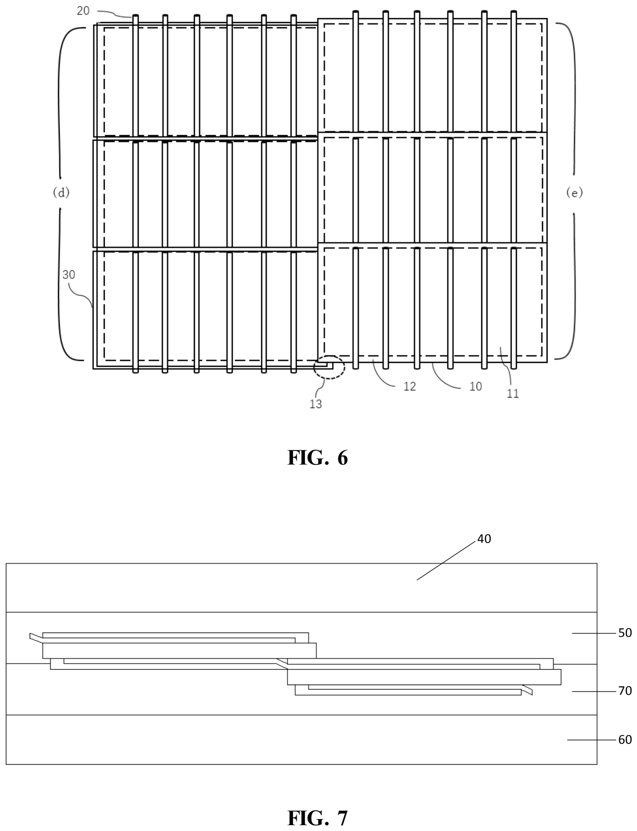

Reference is made to FIG. 6, which is a schematic structural view of a photovoltaic cell panel according to an embodiment of the present application. The photovoltaic cell panel may include multiple photovoltaic cell strings as described above.

The multiple photovoltaic cell strings are laid and electrically connected to each other to form the photovoltaic cell panel.

It should be noted that in this embodiment, the above multiple photovoltaic cell strings are laid and electrically connected to each other to form the photovoltaic cell panel. The specific connection manner of the multiple photovoltaic cell strings is not limited in this embodiment. For example, the multiple cell strings may be connected in parallel or in series, depending on the actual working scenario. FIG. 6 illustrates an example where two groups of photovoltaic cell strings are stacked on each other to form a photovoltaic cell panel, including two groups of cell strings placed as shown in (d) and (e) of FIG. 6. The overlapping region 13 is the region where adjacent cell strings overlap with each other, and the adjacent cell strings are isolated by the protective film 30 at the overlapping region 13.

Furthermore, in order to further reduce the gap between the adjacent cells 10, the cell string overlapping region 13 may exist between every two adjacent cell strings among the above-mentioned multiple photovoltaic cell strings.

The protective film 30 located on a preset cell string surface of at least one of the adjacent cell strings extends into the cell string overlapping region 13. The preset cell string surfaces refer to the surfaces on the sides where the corresponding cells 10 of the adjacent cell strings are stacked on each other.

It should be noted that in this embodiment, the protective films 30 located on the preset surfaces of the adjacent cell strings extend into the cell string overlapping region 13, such that the stress generated between the adjacent cell strings and the welding strip s 20 in the cell string overlapping region 13 may be reduced, thereby improving the structural stability of the photovoltaic cell panel. The number of protective films 30 of the adjacent cell strings extending into the cell string overlapping region 13 is not limited in this embodiment. For example, the protective film 30 located on the preset surface of one of the adjacent cell strings may extend into the cell string overlapping region 13. Alternatively, the protective films 30 located on the preset surfaces of both of the adjacent cell strings may extend into the cell string overlapping region 13, respectively.

Furthermore, in order to prevent the light-collecting regions of the corresponding cell strings of the adjacent cell strings from being blocked, the length of the cell string overlapping region may be less than 5mm.

It should be noted that in this embodiment, providing the length of the cell string overlapping region to be less than 5mm may prevent the light-collecting regions of the adjacent cell strings from being blocked.

The photovoltaic cell panel according to the embodiment of the present application includes multiple photovoltaic cell strings as described in the above embodiments, and the multiple photovoltaic cell strings are laid and electrically connected to each other to form the photovoltaic cell panel. Each of the above photovoltaic cell strings includes: multiple cells 10, welding strips 20 arranged on first surfaces and second surfaces of the cells 10, and protective films 30 arranged on outer sides of the welding strips 20. There is an overlapping region 13 between every two adjacent cells 10 among the multiple cells 10. The protective film 30 located on the preset cell surfaces of the adjacent cells 10 extend into the overlapping region 13, such that the stress generated between the cells 10 and the welding strips 20 in the overlapping region 13 is reduced by means of the protective films 30.The preset cell surfaces refer to the surfaces of the cells on the sides where the adjacent cells 10 are stacked on each other. The adjacent cells 10 are electrically connected to each other by means of the welding strips 20 located on the preset cell surfaces. In this embodiment, the welding strips 20 located on both sides of the preset surface between the adjacent cells 10 among the multiple photovoltaic cell strings are electrically connected to each other, so that a negative electrode of one of the adjacent cells 10 is connected to a positive electrode of the other of the adjacent cells 10, thereby achieving a series connection between the adjacent cells 10. Moreover, in the embodiment of the present application, extending the protective films 30 located on the preset cell string surfaces of the adjacent cell string into the cell string overlapping region 13, the area of the non-power generation region in the module is reduced, and the stress generated between the cell 10 and the welding strip 20 is reduced, thereby improving the structural stability of the photovoltaic cell panel. Providing the length of the cell string overlapping region to be less than 5mm may prevent the light-collecting regions of the adjacent cell strings from being blocked.

Another photovoltaic cell panel according to an embodiment of the present application is described below. The photovoltaic cell panel described below and the photovoltaic cell string described above may be referred to each other.

The photovoltaic cell panel according to the embodiment of the present application may include:
multiple photovoltaic cell strings as described above.

The multiple photovoltaic cell strings are laid and electrically connected to each other to form the photovoltaic cell panel. There is a cell string overlapping region between every two adjacent cell strings among the multiple photovoltaic cell strings.

The protective film located on the preset cell string surface of each of the adjacent cell strings extends into the cell string overlapping region. The preset cell string surfaces refer to the surfaces on the sides where the corresponding cells of the adjacent cell strings are stacked on each other.

In this embodiment, by extending the protective film located on the preset cell string surface of each of the adjacent cell strings into the cell string overlapping region, the risk of hidden cracks in the formed photovoltaic cell panel may be further reduced, thereby improving the yield of the photovoltaic cell panel

The photovoltaic cell panel according to the embodiment of the present application includes multiple photovoltaic cell strings as described above, which are laid and electrically connected to each other to form the photovoltaic cell panel. There is a cell string overlapping region between every two adjacent cell strings among the multiple photovoltaic cell strings, and the protective film located on the preset cell string surface of each of the adjacent cell strings extends into the cell string overlapping region. The preset cell string surfaces refer to the surfaces on the sides where the corresponding cells of the adjacent cell strings are stacked on and in contact with each other. In the embodiment of the present application, the yield of the photovoltaic cell panel is further improved by extending the protective film located on the preset cell string surface of each of the adjacent cell strings into the cell string overlapping region.

A photovoltaic cell module according to an embodiment of the present application is described below. The photovoltaic cell module described below and the photovoltaic cell panel described above can be referred to each other.

Reference is made to FIG. 7, which is a schematic structural view of a photovoltaic cell module according to an embodiment of the present application. The photovoltaic cell module may include:
a first panel 40, a first adhesive film layer 50, a second panel 60, a second adhesive film layer 70, and the photovoltaic cell panel as described above.

The first adhesive film layer 50 and the second adhesive film layer 70 are arranged on both sides of the photovoltaic cell panel respectively, and the photovoltaic cell panel is sealed between the first adhesive film layer 50 and the second adhesive film layer 70.

The first panel 40 is arranged on an outer side of the first adhesive film layer 50, and the second panel 60 is arranged on an outer side of the second adhesive film layer 70.

It should be noted that in this embodiment, adhesive film layers are arranged on the outer sides of the photovoltaic cell panel for encapsulation, thereby improving the sealing performance of the encapsulation. In this embodiment, each of the first adhesive film layer 50 and the second adhesive film layer 70 may be formed of transparent polymer materials such as EVA, POE, co-extruded EPE, PVB or organic silica gel. Furthermore, the adhesive film layer may be made of POE or EVA. In this embodiment, after the above photovoltaic cell module is assembled, the photovoltaic cell module may be subjected to lamination, with a lamination temperature higher than the melting point of a tin layer of the low-temperature welding strip. After the lamination is completed, electrical connection is formed between the cells.

The photovoltaic cell module according to the embodiment of the present application includes: a first panel 40, a first adhesive film layer 50, a second panel 60, a second adhesive film layer 70, and the photovoltaic cell panel as described above. The first adhesive film layer 50 and the second adhesive film layer 70 are arranged on both sides of the photovoltaic cell panel respectively, and the photovoltaic cell panel is sealed between the first adhesive film layer 50 and the second adhesive film layer 70. The first panel 40 is arranged on an outer side of the first adhesive film layer 50, and the second panel 60 is arranged on an outer side of the second adhesive film layer 70. The above photovoltaic cell panel includes multiple photovoltaic cell strings, which are laid and electrically connected to each other to form the photovoltaic cell panel. Each of the above photovoltaic cell strings includes: multiple cells, welding strips arranged on first surfaces and second surfaces of the cells, and protective films arranged on outer sides of the welding strips. Adjacent cells among the multiple cells are lapped on each other so that a lapping region between the adjacent cells forms the overlapping region. The protective films located on preset cell surfaces of the adjacent cells extend into the overlapping region, such that the stress generated between the cells and the welding strips in the overlapping region is reduced by means of the protective films. The preset cell surfaces refer to the surfaces of the cells on the sides where the adjacent cells are lapped on each other. The welding strips located on the preset cell surfaces of the adjacent cells are electrically connected to each other to achieve a series connection between the adjacent cells. In the present application, the welding strip and the zero-busbar cell may be pre-fixed to each other by the protective film, and since the protective film has lower fluidity than that of the outer encapsulating adhesive film layer, which may prevent displacement of the welding strip and reduce the occurrence of cold welding joints. Furthermore, by extending the protective films located on the preset cell surfaces of the adjacent cells into the overlapping region, the stress generated between the cells and the welding strips may be reduced, the manufacturing difficulty of the photovoltaic cell string may be reduced, and the manufacturing cost may be reduced, thereby improving the manufacturing efficiency of the photovoltaic cell string.

A method for manufacturing a photovoltaic cell string according to an embodiment of the present application is described below. The method for manufacturing the photovoltaic cell string described below and the photovoltaic cell string described above may be referred to each other.

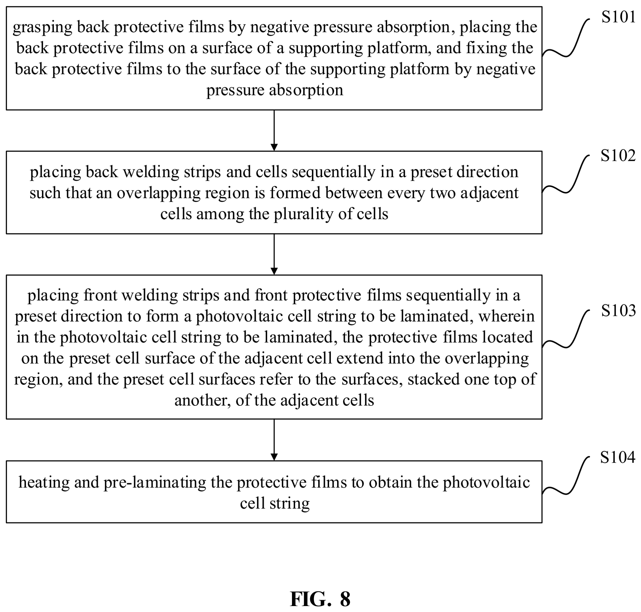

Reference is made to FIG. 8, which is a flow chart of a method for manufacturing a photovoltaic cell string according to an embodiment of the present application. The method may include following steps.

In S101, back protective films are grasped by negative pressure absorption, placed on a surface of a supporting platform, and fixed to the surface of the supporting platform by negative pressure absorption.

In this embodiment, negative pressure absorption is utilized to grasp the back protective film to transfer it to the surface of the supporting platform. The back protective film is then fixed to the surface of the supporting platform by negative pressure absorption for subsequent alignment and mounting, thereby ensuring the automation degree of manufacturing and improving manufacturing efficiency.

In S102, back welding strips and cells are placed sequentially in a preset direction so that an overlapping region is formed between every two adjacent cells among the multiple cells.

In this embodiment, an overlapping region is formed by lapping the adjacent cells among the multiple cells on each other, thereby reducing the area of the non-power generation region on the cell.

In S103, front welding strips and front protective films are placed sequentially in a preset direction to form a photovoltaic cell string to be laminated. In the photovoltaic cell string to be laminated, the protective films located on the preset cell surfaces of the adjacent cells extend into the overlapping region. The preset cell surfaces refer to the surfaces, stacked one on top of another, of the adjacent cells.

The protective films located on the preset cell surfaces are extended into the overlapping region, such that the risk of hidden cracks in the cells within the overlapping region between the cells is reduced.

In S104, the protective films are heated and pre-laminated to obtain a photovoltaic cell string.

By heating and pre-pressing the protective films, the structural stability of the photovoltaic cell string is ensured, preventing any displacement of internal components during the subsequent manufacturing processes.

Furthermore, in order to ensure the sealing performance of the photovoltaic cell string, after the protective films are heated and pre-laminated to obtain the photovoltaic cell string, the method may further include the following step.

Protective adhesive film layers are arranged on both sides of the photovoltaic cell string respectively, and are laminated to weld and fix the back welding strips and the front welding strips to fingers on cell surfaces.

It should be noted that in this embodiment, the protective adhesive film layers are arranged on both sides of the photovoltaic cell string respectively, and are laminated, such that the back welding strips and the front welding strips may be welded and fixed to the fingers on the cell surfaces at the lamination temperature, further ensuring the structural stability.

The method for manufacturing a photovoltaic cell string according to the embodiment of the present application includes the following steps: grasping back protective films by negative pressure absorption, placing them on a surface of a supporting platform, and fixing the back protective films to the surface of the supporting platform by negative pressure absorption; placing back welding strips and cells sequentially in a preset direction so that an overlapping region is formed between every two adjacent cells among the multiple cells; placing front welding strips and front protective films sequentially in a preset direction to form a photovoltaic cell string to be laminated, in the photovoltaic cell string to be laminated, the protective films located on the preset cell surfaces of the adjacent cells are extended into the overlapping region, and the preset cell surfaces refer to the surfaces of the cells on the sides where the adjacent cells are stacked on each other; and heating and pre-laminating the protective films to obtain a photovoltaic cell string. In the present application, the protective films located on the preset cell surfaces of the adjacent cells extend into the overlapping region, such that the area of the non-power generation region within the module may be reduced, and the stress generated between the cells and the welding strips may be reduced. Furthermore, the manufacturing difficulty of the photovoltaic cell string may be reduced, and the manufacturing cost may be reduced, thereby improving the manufacturing efficiency of the photovoltaic cell string. In the present application, the back protective films (the back refers to the side closer to a conveyor belt) are grasped by absorption, and placed on the surface at the preset positions of the conveyor belt. The protective films are then absorbed and transported by the conveyor belt. Subsequently, the back welding strips and cells, followed by front welding strips and front protective films are sequentially placed at the predetermined positions. The manufacturing method employs absorption-based grasping and simple alignment, which may improve the efficiency and yield of manufacturing.

The above embodiments in this specification are described in a progressive manner. Each of the embodiments is mainly focused on describing its differences from other embodiments, and reference may be made among these embodiments with respect to the same or similar parts. Since the device disclosed in the embodiments corresponds to the method disclosed in the embodiments, the description of the device is simple, and reference may be made to the relevant part of the method.

It should be further noted that in the present application, the relationship terms such as "first" and "second" are only used to distinguish one entity or operation from another entity or operation, rather than to necessitate or imply an actual relationship or order between the entities or operations. Moreover, terms such as "include", "comprise" or any other variants are intended to be non-exclusive. Therefore, a process, method, article or device including a series of elements includes not only the elements but also other elements that are not explicitly listed, or further includes elements inherent to the process, method, article or device.

A photovoltaic cell string, a photovoltaic cell panel, a photovoltaic module, and a method for manufacturing a photovoltaic cell string according to the present application are described in detail above. Although the principles and implementations of the present application are described by using specific embodiments in the present application, the descriptions of the above embodiments are merely intended to help understand the method and the core concept of the method of the present application. In addition, those skilled in the art may make modifications to the specific implementations and application scope based on the concept of the present application. In conclusion, the content of this specification is not to be construed as a limit on the present application.

## Claims

1. A photovoltaic cell string, comprising:
a plurality of cells, welding strips arranged on first surfaces and second surfaces of the cells, and protective films arranged on outer sides of the welding strips;
wherein there is an overlapping region between every two adjacent cells among the plurality of cells;
the protective films located on preset cell surfaces of the adjacent cells extend into the overlapping region, so that stress generated between the cells and the welding strips in the overlapping region is reduced by the protective films, and the preset cell surfaces refer to surfaces, which are stacked one on top of another, of the adjacent cells; and
the adjacent cells are electrically connected to each other by the welding strips located on the preset cell surfaces.

2. The photovoltaic cell string according to claim 1, wherein the protective film located on the preset cell surface of one of the adjacent cells extends into the overlapping region.

3. The photovoltaic cell string according to claim 1, wherein the protective films located on the preset cell surfaces of both of the adjacent cells extend into the overlapping region, respectively.

4. The photovoltaic cell string according to claim 1, wherein the protective film has an intact surface.

5. The photovoltaic cell string according to claim 1, wherein an independent protective film is arranged on each of the first surface and the second surface of each of the cells.

6. The photovoltaic cell string according to claim 1, wherein the protective film is a polymer film.

7. The photovoltaic cell string according to claim 6, wherein the polymer film has a thickness ranging from 50µm to 150µm.

8. The photovoltaic cell string according to claim 1, wherein the overlapping region between the adjacent cells has a length ranging from 0.2mm to 5mm.

9. The photovoltaic cell string according to claim 1, wherein there is a gap region formed between an edge of the protective film and an edge of the cell, allowing a portion of the preset cell surface to be exposed.

10. The photovoltaic cell string according to claim 9, wherein the gap region is located at the edges of the adjacent cells that are opposite to each other.

11. The photovoltaic cell string according to claim 10, wherein the gap region has a width ranging from 0.5mm to 10mm.

12. A photovoltaic cell panel, comprising:
a plurality of photovoltaic cell strings according to any one of claims 1 to 11;
wherein the plurality of photovoltaic cell strings are laid and electrically connected to each other to form a photovoltaic cell panel.

13. The photovoltaic cell panel according to claim 12, wherein there is a cell string overlapping region between every two adjacent cell strings among the plurality of photovoltaic cell strings; and
the protective film located on a preset cell string surface of at least one of the adjacent cell strings extends into the cell string overlapping region, and the preset cell string surfaces refer to the surfaces, which are stacked one on top of another, of the corresponding cells of the adjacent cell strings.

14. The photovoltaic cell panel according to claim 13, wherein the cell string overlapping region has a length less than 5mm.

15. A photovoltaic cell panel, comprising:
a plurality of photovoltaic cell strings according to any one of claims 1 to 11;
wherein the plurality of photovoltaic cell strings are laid and electrically connected to each other to form a photovoltaic cell panel;
there is a cell string overlapping region between every two adjacent cell strings among the plurality of photovoltaic cell strings;
the protective film located on a preset cell string surface of each of the adjacent cell strings extends into the cell string overlapping region; and
the preset cell string surfaces refer to the surfaces, which are stacked one on top of another, of the corresponding cells of the adjacent cell strings.

16. A photovoltaic cell module, comprising:
a first panel, a first adhesive film layer, a second panel, a second adhesive film layer, and the photovoltaic cell panel according to any one of claims 12 to 14 or claim 15;
wherein the first adhesive film layer and the second adhesive film layer are arranged on both sides of the photovoltaic cell panel respectively, and the photovoltaic cell panel is sealed between the first adhesive film layer and the second adhesive film layer; and
the first panel is arranged on an outer side of the first adhesive film layer, and the second panel is arranged on an outer side of the second adhesive film layer.

17. A method for manufacturing a photovoltaic cell string, comprising:
grasping back protective films by negative pressure absorption, placing the back protective films on a surface of a supporting platform, and fixing the back protective films to the surface of the supporting platform by negative pressure absorption;
placing back welding strips and cells sequentially in a preset direction such that an overlapping region is formed between every two adjacent cells among the plurality of cells;
placing front welding strips and front protective films sequentially in a preset direction to form a photovoltaic cell string to be laminated, wherein in the photovoltaic cell string to be laminated, the protective films located on the preset cell surfaces of the adjacent cells extend into the overlapping region, and the preset cell surfaces refer to the surfaces, stacked one on top of another, of the adjacent cells; and
heating and pre-laminating the protective films to obtain the photovoltaic cell string.

18. The method for manufacturing a photovoltaic cell string according to claim 17, wherein after heating and pre-laminating the protective films to obtain the photovoltaic cell string, the method further comprises:
arranging protective adhesive film layers on both sides of the photovoltaic cell string respectively, and laminating them so as to weld and fix the back welding strips and the front welding strips to grid on cell surfaces.
